Europäisches Patentamt

European Patent Office

Office européen des brevets

(11) Veröffentlichungsnummer: **0 307 682 B1**

(12) **EUROPÄISCHE PATENTSCHRIFT**

(45) Veröffentlichungstag der Patentschrift: **25.11.92**

(51) Int. Cl.⁵: **C30B 25/02**, C30B 29/40

(21) Anmeldenummer: **88113914.1**

(22) Anmeldetag: **26.08.88**

(54) **Verfahren zur Herstellung von transparenten Aluminiumnitrid-Folien sowie -Beschichtungen aus Amminsalzen des Aluminiumjodids.**

(30) Priorität: **18.09.87 DE 3731455**

(43) Veröffentlichungstag der Anmeldung:
**22.03.89 Patentblatt 89/12**

(45) Bekanntmachung des Hinweises auf die
Patenterteilung:
**25.11.92 Patentblatt 92/48**

(84) Benannte Vertragsstaaten:
**AT BE CH DE FR GB IT LI NL SE**

(56) Entgegenhaltungen:
**US-A- 3 565 704**

**JAPANESE JOURNAL OF APPLIED PHYSICS,
Band 21, Nr. 7, Teil 1, Juli 1982, Tokyo (JP);
M.MORITA et al., Seiten 1102-1103&NUM;**

**JOURNAL OF CRYSTAL GROWTH, Band 77,
Nr. 1-3, September 1986, Elsevier Science
Publishers B.V., Amsterdam (NL);
D.K.GASKILL et al., Seiten 418-423&NUM;**

(73) Patentinhaber: **HOECHST AKTIENGESELL-
SCHAFT
Postfach 80 03 20
W-6230 Frankfurt am Main 80(DE)**

(72) Erfinder: **Peters, Dieter, Dr.
Schaesbergstrasse 3
W-5030 Hürth(DE)**

**Beschreibung**

Die Erfindung betrifft ein Verfahren zur Herstellung von transparenten Aluminiumnitrid-Folien sowie Aluminiumnitrid-Beschichtungen.

Folien und Beschichtungen aus Aluminiumnitrid werden insbesondere als Hochtemperaturmaterial eingesetzt, da es gute Eigenschaften wie hohe thermische Leitfähigkeit, Korrosionsbeständigkeit und Festigkeit aufweist. Insbesondere können warmfeste Stähle oder deren Legierungen bei Temperaturen oberhalb von 600°C wirkungsvoll gegen Korrosion geschützt werden. Bei der Verwendung als Hochtemperaturschutz gegen Korrosion wird man vorzugsweise eine Aluminiumnitrid-Beschichtung einsetzen; auf Aluminiumnitrid-Folien wird man bevorzugt dann zurückgreifen, wenn es als Fenstermaterial für Sensoren bei hohen Temperaturen benötigt wird.

Aluminiumnitrid-Beschichtungen können beispielsweise durch ein aufwendiges Plasmaspritzverfahren durch Verdampfen von Aluminium in Stickstoff-Atmosphäre bei 1800 - 2000°C oder durch Aufbringen und Sintern von Aluminiumnitridpulvern mit Teilchendurchmessern von kleiner als 2 $\mu$m hergestellt werden.

Aluminiumnitrid-Folien können durch ein teures Sinterverfahren von Aluminiumnitridpulvern hergestellt werden.

Im "Japanese Journal of Applied Physics, Vol. 21, No. 7, Part 1, p. 1102 - 1103, Tokyo, JP; M. Morita et al.: Optical absorption and cathodoluminescence of epitaxial aluminum nitride films" werden Aluminiumnitrid-Filme beschrieben, die durch Zersetzung von Trimethylaluminium erhalten wurden.

Es war daher die Aufgabe gestellt, ein Verfahren zur Herstellung von tranparenten Aluminiumnitrid-Folien sowie Aluminiumnitrid-Beschichtungen bereitzustellen, das einfach und kostengünstig durchführbar ist.

Diese Aufgabe wird erfindungsgemäß dadurch gelöst, daß die Aluminiumnitrid-Folie aus einem Einkristall besteht und durch Verdampfung von Amminsalzen des Aluminiumjodids in einer Verdampfungszone und anschließende Ammonolyse in einer Zersetzungszone bei 380 bis 550°C erhalten werden und die Aluminiumnitrid-Beschichtungen durch Verdampfung von Amminsalzen des Aluminiumjodids in einer Verdampfungszone und anschließende Ammonolyse in einer Zersetzungszone bei Temperaturen zwischen 550 und 1200°C erhalten werden.

Gemäß der vorliegenden Erfindung werden als Ausgangsstoffe für die Ammonolyse bevorzugt Hexa- und/oder Pentaamminaluminiumjodid und/oder Hexaamminaluminiumjodidmonoammoniakat eingesetzt.

Erfindungsgemäß kann das Amminsalz des Aluminiumjodids aus der Verdampfungszone mittels eines sauerstoff- und wasserfreien Trägergases in die Zersetzungszone transportiert werden.

Erfindungsgemäß können als Trägergas Ammoniak, Edelgas, Stickstoff, Wasserstoff sowie deren Mischungen eingesetzt werden.

Gute Ergebnisse werden erzielt, wenn die Verdampfungs- und Zersetzungszone unter einem Druck von 0,01 bis 3 bar betrieben werden, wobei die Verdampfungszone auf einer Temperatur zwischen 200 und 380°C, insbesondere zwischen 350 und 370°C, gehalten wird.

Eine Verfahrensvariante liegt vor, wenn das Amminsalz des Aluminiumjodids durch Überleiten von Ammoniak über Aluminiumjodid bei einer Temperatur von 200 bis 380°C, insbesondere bei 350 bis 370°C, in der Verdampfungszone gebildet wird und mit überschüssigem Ammoniak als Trägergas in die Zersetzungszone gefördert wird.

Es hat sich gezeigt, daß die Aluminiumnitrid-Folie gut abziehbar ist, wenn sie an einer erhitzten Quarzfläche als Zersetzungszone als Einkristall abgeschieden wird.

Eine Verfahrensvariante liegt vor, wenn Pentaamminaluminiumjodid in der Verdampfungszone bei 350 bis 380°C in Abwesenheit von Fremdgasen verdampft wird und bei 380 bis 1200°C in der Zersetzungszone zersetzt wird.

Erfindungsgemäß werden einkristalline transparente Aluminiumnitrid-Folien mit einer Dicke von bis 20 $\mu$m und einer Oberflächenrauhigkeit von kleiner als 0,3 $\mu$m, besonders kleiner 0,1 $\mu$m, insbesondere kleiner als 0,01 $\mu$m, hergestellt, bei der die kristallografische C-Achse senkrecht zur Folienebene angeordnet ist.

Erfindungsgemäß wird eine transparente Aluminiumnitrid-Beschichtung hergestellt, bei der die kristallografische C-Achse senkrecht zur Beschichtungsfläche angeordnet ist.

Die Orientierung der C-Achse wurde mittels Röntgenaufnahmen und dem Verhalten bei Betrachtung im polarisierten Licht bestimmt. Rasterelektronenmiskrop-Aufnahmen zeigten, daß die Aluminiumnitrid-Folien und -Beschichtungen dicht sind und eine sehr glatte Oberfläche aufweisen, deren Rauhigkeit kleiner als 0,3 $\mu$m, besonders kleiner 0,1 $\mu$m, insbesondere kleiner als 0,01 $\mu$m, ist.

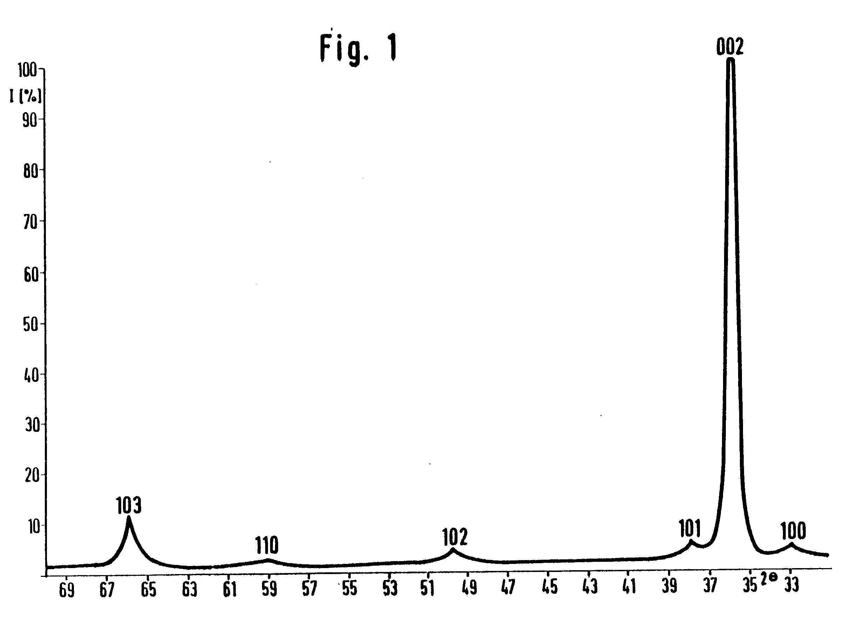

Die Abbildung 1 zeigt die Röntgenaufnahme einer Aluminiumnitrid-Folie, die gemäß Beispiel 1 hergestellt wurde. In der Röntgenaufnahme sind nur die 002 und 103 Reflexe sichtbar.

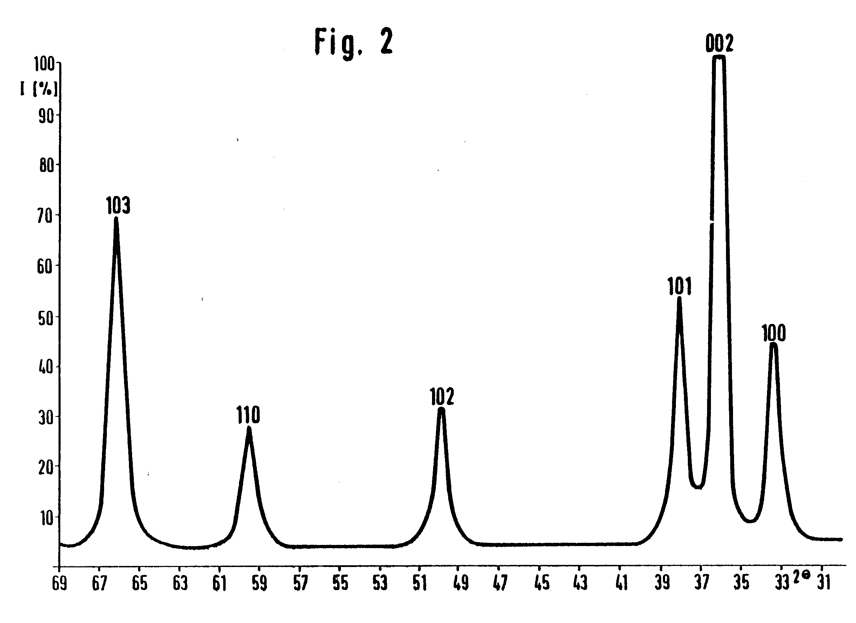

Die Abbildung 2 zeigt das Röntgendiagramm der nach Beispiel 1 erhaltenen, gemörserten Aluminiumnitrid-Folie. Aus der Textur des Röntgendiagramms ist zu entnehmen, daß die C-Achse des Einkristalls senkrecht zur Folienachse angeordnet ist.

Die nachfolgenden Beispiele dienen zur Erläuterung der Erfindung, ohne daß darin eine Einschränkung zu sehen ist.

Beispiel 1

Herstellung einer Aluminiumnitrid-Folie (Ausgangsmaterial:Hexaamminaluminiumjodidmonoammoniakat)

In einem emaillierten, heizbaren Rührautoklaven wurden unter Inertgas ($N_2$, Ar) 27 Teile Aluminiumschnitzel und 435 Teile Ammoniumjodid vorgelegt. Nach Evakuieren des Autoklaven wurden 561 Teile Ammoniak einkondensiert. Nach Verschließen des Autoklaven wurde er auf 75°C erhitzt und 99 Stunden bei dieser Temperatur belassen. Es stellte sich ein Druck von 35 bar ein. Anschließend wurde der Autoklav bei Raumtemperatur auf Normaldruck entspannt. Das Produkt hatte folgende Analyse:

$Al_{0,179}$ $I_{0,573}$ $N_{1,289}$

und entsprach damit der Formel

$[Al(N_3)_6] I_3(NH_3) + 0,201 NH_4 I$

Bezogen auf das Aluminium betrug die Ausbeute 94 %.

Das so hergestellte $[Al(NH_3)_6] I_3(NH_3)$ wurde in einem Quarzrohr bei 375°C verdampft und mit $NH_3$-Gas bei 1,1 bar in die Zersetzungszone transportiert. Die Temperatur in der Zersetzungszone betrug 430°C. Auf der Quarzwand bildeten sich transparente Folien, die nach Abkühlen auf Raumtemperatur leicht vom Quarzrohr abziehbar waren.

Beispiel 2

Herstellung einer Aluminiumnitrid-Folie (Ausgangsmaterial:Pentaamminaluminiumjodid)

27 Teile Aluminiumschnitzel, 381 Teile Jod und 4 Teile Ammoniumchlorid wurden unter Inertgas ($N_2$, Ar) im Autoklaven vorgelegt und nach Evakuieren 540 Teile Ammoniak eindosiert. Der Autoklav wurde auf 320°C erhitzt und 7 Stunden bei dieser Temperatur und einem Druck von 180 bar gehalten. Anschließend wurde der Autoklav bei einer Temperatur von 320°C gegen Normaldruck entspannt.
Das Produkt hatte folgende Analyse:

$Al_{0,182}$ $I_{0,612}$ $N_{0,985}$
und entsprach damit der Formel

$[Al(NH_3)_{5,05}] I_3 + 0,363 NH_4 I$

Bezogen auf Aluminium betrug die Ausbeute 89 %.

Das so hergestellte Pentaamminaluminiumjodid wurde in einem Quarzrohr bei 370°C ohne Fremdgase verdampft. Bei 500°C bildeten sich in der Zersetzungszone transparente Aluminiumnitrid-Folien, die bei Raumtemperatur leicht von der Quarzwand abziehbar waren.

Beispiel 3

Herstellung einer Aluminiumnitrid-Beschichtung (Ausgangsmaterial:Hexaamminaluminiumjodid)

In den Autoklaven wurden unter Inertgas ($N_2$, Ar) 27 Teile Aluminiumschnitzel, 435 Teile Ammoniumjodid und 4 Teile Ammoniumchlorid vorgelegt. Nach Evakuieren wurden 580 Teile Ammoniak einkondensiert. Nach Verschließen des Autoklaven wurde er auf 120°C erhitzt und 8 Stunden bei einem Druck von 90 bar gehalten. Danach wurde er bei 120°C gegen Normaldruck entspannt.
Das Produkt hatte folgende Analyse:

$Al_{0,181}$ $I_{0,591}$ $N_{1,156}$ $Cl_{0,015}$
und entsprach damit der Formel

$[Al(NH_3)_{6,04}] I_3 + 0,240 NH_4 I + 0,075 NH_4 Cl$

Bezogen auf Aluminium betrug die Ausbeute 92 %.

Das so hergestellte Hexaamminaluminiumjodid wurde in einem Quarzrohr bei 375°C im $NH_3$-Strom verdampft. In der Zersetzungszone wurden bei 560°C Aluminiumoxidplatten senkrecht zur Strömungsrichtung aufgestellt. Nach beendeter Reaktion hatte sich auf den $Al_2O_3$-Platten eine zusammenhängende dichte Aluminiumnitridschicht gebildet.

Beispiel 4

Herstellung einer Aluminiumnitrid-Beschichtung (Ausgangsmaterial in der Verdampfungszone: Aluminiumjodid)

Käufliches $AlI_3$ der Firma Ventron, Karlsruhe, wurde zweimal über Aluminium der Firma VAW, Bonn, destilliert.
Aluminiumjodid wurde bei 350°C in einem Quarzrohr verdampft und mit $NH_3$-Gas zur Reaktion gebracht. Durch überschüssiges $NH_3$ wurde das Reaktionsprodukt in die Zersetzungszone transportiert und dort bei 600°C auf Aluminiumoxidplatten eine Aluminiumnitridschicht erzeugt. Die Aluminiumnitridschicht war zusammenhängend und dicht.

**Patentansprüche**

1. Verfahren zur Herstellung von transparenten Aluminiumnitrid-Folien, dadurch gekennzeichnet, daß die Aluminiumnitrid-Folien aus einem Einkristall bestehen und durch Verdampfung von Amminsalzen des Aluminiumjodids in einer Verdampfungszone und anschließende Ammonolyse in einer Zersetzungszone bei 380 bis 550°C erhalten werden.

2.  Verfahren zur Herstellung von transparenten Aluminiumnitrid-Beschichtungen, dadurch gekennzeichnet, daß die Aluminiumnitrid-Beschichtungen durch Verdampfung von Amminsalzen des Aluminiumjodids in einer Verdampfungszone und anschließende Ammonolyse in einer Zersetzungszone bei Temperaturen zwischen 550 und 1200°C erhalten werden.

3.  Verfahren nach Anspruch 1 oder 2, dadurch gekennzeichnet, daß als Ausgangsstoff für die Ammonolyse Hexa- und/oder Pentaamminaluminiumjodid und/oder Hexaamminaluminiumjodidmonoammoniakat eingesetzt werden.

4.  Verfahren nach einem der Ansprüche 1 bis 3, dadurch gekennzeichnet, daß das Amminsalz des Aluminiumjodids aus der Verdampfungszone mittels eines sauerstoff- und wasserfreien Trägergases in die Zersetzungszone transportiert wird.

5.  Verfahren nach Anspruch 4, dadurch gekennzeichnet, daß als Trägergas Ammoniak, Edelgas, Stickstoff, Wasserstoff sowie deren Mischungen eingesetzt werden.

6.  Verfahren nach einem der Ansprüche 1 bis 5, dadurch gekennzeichnet, daß die Verdampfungs- und Zersetzungszone unter einem Druck von 0,01 bis 3 bar betrieben werden, wobei die Verdampfungszone auf einer Temperatur zwischen 250 und 380°C, insbesondere zwischen 350 und 370°C, gehalten wird.

7.  Verfahren nach Anspruch 1 oder 2, dadurch gekennzeichnet, daß das Amminsalz des Aluminiumjodids durch Überleiten von Ammoniak über Aluminiumjodid bei einer Temperatur von 200 bis 380°C, insbesondere bei 350 bis 370°C, in der Verdampfungszone gebildet wird und mit überschüssigem Ammoniak als Trägergas in die Zersetzungszone gefördert wird.

8.  Verfahren nach einem der Ansprüche 1 und 3 bis 7, dadurch gekennzeichnet, daß die Aluminiumnitrid-Folie an einer erhitzten Quarzfläche als Zersetzungszone als Einkristall abgeschieden wird.

9.  Einkristalline transparente Aluminiumnitrid-Folien mit einer Dicke von bis 20 μm und einer Oberflächenrauhigkeit von kleiner als 0,3 μm, vorzugsweise kleiner als 0,1 μm, insbesondere kleiner als 0,01 μm, bei denen die kristallografische C-Achse senkrecht zur Folienebene angeordnet ist.

**Claims**

1.  A process for the production of a transparent aluminum nitride film, wherein the aluminum nitride film comprises a monocrystal and is obtained by evaporation of ammine salts of aluminum iodide in an evaporation zone and subsequent ammonolysis in a decomposition zone at 380 to 550°C.

2.  A process for the production of a transparent aluminum nitride coating, wherein the aluminum nitride coating is obtained by evaporation of ammine salts of aluminum iodide in an evaporation zone and subsequent ammonolysis in a decomposition zone at temperatures between 550 and 1200°C.

3.  The process as claimed in claim 1 or 2, wherein the starting material employed for the ammonolysis is hexamminealuminum iodide and/or pentaamminealuminum iodide and/or hexamminealuminum iodide monoammoniate.

4.  The process as claimed in any of claims 1 to 3, wherein the ammine salt of aluminum iodide is transported out of the evaporation zone into the decomposition zone by means of an oxygen-free and water-free carrier gas.

5.  The process as claimed in claim 4, wherein the carrier gas employed is ammonia, a noble gas, nitrogen, hydrogen or a mixture thereof.

6.  The process as claimed in any of claims 1 to 5, wherein the evaporation and decomposition zones are operated at a pressure of 0.01 to 3 bar, the evaporation zone being kept at a temperature between 250 and 380°C, in particular between 350 and 370°C.

7.  The process as claimed in claim 1 or 2, wherein the ammine salt of aluminum iodide is formed in the evaporation zone by passing ammonia over aluminum iodide at a temperature of 200 to 380°C, in particular at 350 to 370°C and transported into the decomposition zone using excess ammonia as the carrier gas.

8.  The process as claimed in any of claims 1 and 3 to 7, wherein the aluminum nitride film is deposited as a monocrystal on a heated quartz surface as the decomposition zone.

9. A monocrystalline, transparent aluminum nitride film having a thickness of up to 20 $\mu$m and a surface roughness of less than 0.3 $\mu$m, preferably less than 0.1 $\mu$m, in particular less than 0.01 $\mu$m, and in which the crystallographic C axis is perpendicular to the film plane.

**Revendications**

1. Procédé pour la fabrication de feuilles transparentes de nitrure d'aluminium, caractérisé en ce que les feuilles de nitrure d'aluminium consistent en un monocristal et sont obtenues par vaporisation de sels d'ammines de l'iodure d'aluminium dans une zone d'évaporation et ensuite ammonolyse dans une zone de décomposition à 380-550°C.

2. Procédé pour la fabrication de revêtements transparents de nitrure d'aluminium, caractérisé en ce que les revêtements de nitrure d'aluminium sont obtenus par évaporation de sels d'ammines de l'iodure d'aluminium dans une zone d'évaporation et ensuite ammonolyse dans une zone de décomposition à des températures comprises entre 550 et 1200°C.

3. Procédé selon la revendication 1 ou 2, caractérisé en ce que l'on utilise comme produit de départ pour l'ammonolyse l'iodure d'aluminium hexammine et/ou l'iodure d'aluminiumpentammine et/ou le monoammoniacate d'iodure d'aluminiumhexammine.

4. Procédé selon l'une des revendications 1 à 3, caractérisé en ce que le sel d'ammine de l'iodure d'aluminium est transporté de la zone d'évaporation dans la zone de décomposition au moyen d'un gaz porteur exempt d'oxygène et d'eau.

5. Procédé selon la revendication 4, caractérisé en ce que l'on utilise comme gaz porteur l'ammoniac, un gaz rare, l'azote, l'hydrogène et leurs mélanges.

6. Procédé selon l'une des revendications 1 à 5, caractérisé en ce que la zone d'évaporation et la zone de décomposition fonctionnent sous une pression de 0,01 à 3 bar, la zone d'évaporation étant maintenue à une température comprise entre 250 et 380°C, en particulier entre 350 et 370°C.

7. Procédé selon la revendication 1 ou 2, caractérisé en ce que le sel d'ammine de l'iodure d'aluminium est formé dans la zone d'évaporation par passage d'ammoniac sur de l'iodure d'aluminium à une température de 200 à 380°C, en particulier à 350-370°C et transporté dans la zone de décomposition par l'ammoniac en excès comme gaz porteur.

8. Procédé selon l'une des revendications 1 et 3 à 7, caractérisé en ce que la feuille de nitrure d'aluminium est déposée sous forme d'un monocristal sur une surface de quartz chauffée comme zone de décomposition.

9. Feuilles transparentes de nitrure d'aluminium monocristallin d'une épaisseur allant jusqu'à 20 $\mu$m et d'une rugosité de surface de moins de 0,3 $\mu$m, de préférence moins de 0,1 $\mu$m, en particulier moins de 0,01 $\mu$m, dans lesquelles l'axe cristallographique C est perpendiculaire au plan de la feuille.

Fig. 1

EP 0 307 682 B1

Fig. 2

EP 0 307 682 B1